# EUROPEAN PATENT APPLICATION

(11) **EP 2 827 395 A1**
(43) Date of publication of application: **21.01.2015**
(21) Application number: 14150428.2
(22) Date of filing: 08.01.2014
(51) Int. Cl.: H01L 43/08, H01L 43/12, H01L 27/22

(54) **Method for patterning a magnetic tunnel junction stack**

(30) Priority: 16.07.2013 EP 13176613
(71) Applicant: IMEC, 3001 Leuven (BE)
(72) Inventor: Min, Tai, 3001 Leuven (BE); Paraschiv, Vasile, 3001 Leuven (BE); Boullart, Werner, 3001 Leuven (BE); Popovici, Mihaela Ioana, 3001 Leuven (BE)
(74) Representative: Clerix, André

(57) **Abstract**

A method for patterning a magnetic tunnel junction (MTJ) element is disclosed, the method comprising providing a tunneling barrier layer (102) sandwiched in between a top ferromagnetic layer (103) and a bottom ferromagnetic layer (101); the top ferromagnetic layer comprising outer parts (121, 122) and a middle part (120), and introducing metal or metalloid elements Z together with ion elements E into the outer parts of the top ferromagnetic layer thereby modifying the ferromagnetic properties of the outer parts of the top ferromagnetic layer into insulating properties.

## Description

### Field of the disclosure

The present disclosure relates to the field of a magnetic memory element having a magnetic tunnel junction (MTJ) stack and particularly to a method for patterning such a magnetic tunnel junction stack.

### State of the art

Magnetic random access memory (MRAM) is emerging as an alternative for conventional semiconductor memories. Compared to SRAM and DRAM, MRAM has the advantage of being a non-volatility memory. Compared to flash memory used for storage of information, MRAM has an increased endurance as an advantage. However, in order to compete with flash memory, it is necessary to increase the density of the MRAM cells in a chip, which implies keeping the MRAM cells as small as possible. In order to compete with SRAM and DRAM, increasing the speed of operation of the MRAM cell without compromising the cell density is important.
In the earlier part of the last decade, an MRAM type, known as field-switchable MRAM was studied. More recently, an MRAM type known as spin-torque transfer based MRAMs (STT-MRAMs) has become popular. STT-MRAM is potentially scalable to very small sizes. However, the smallest possible STT-MRAM cell size is not only limited by thermal stability, but also by the writability thereof. Two geometries - one with magnetization in plane and another with magnetization out-of-plane (perpendicular) - are being investigated. Out-of-plane magnetization seems to be the more promising for the future, especially from switching and thermal stability perspectives.
A STT-MRAM device typically comprises a magnetic tunnel junction (MTJ) element which in turn comprises a tunneling spacer layer or barrier layer sandwiched in between a ferromagnetic hard layer (comprising a fixed magnetic layer and a pinning layer) and a ferromagnetic soft layer (also often referred to as a 'free layer'). For a bottom pinned MTJ stack the bottom ferromagnetic layer refers to the hard layer and the top ferromagnetic layer refers to the soft layer. For a top pinned MTJ stack, the bottom ferromagnetic layer refers to the soft layer and the top ferromagnetic layer refers to the hard layer. The direction of magnetization of the hard layer is fixed, whereas the direction of magnetization of the soft layer can be changed by passing a drive current through it, which drive current is spin-polarized by the magnetization of the hard layer. When the direction of magnetization of the hard layer and the soft layer are parallel, the MTJ element is in low resistance. When the direction of magnetization of the hard layer and the soft layer are antiparallel, the MTJ element is in high resistance.
The fabrication process of such a MTJ element typically involves the deposition of a stack of layers (hard layer, tunneling barrier layer and soft layer) followed by patterning the stack of layers. Patterning of a MTJ element is one of the most critical aspects of fabrication in MRAM technology, as this involves etching portions of the stack of layers whereby almost all the layers used in such a stack form nonvolatile byproducts. The etching process may thus leave residues on the patterned layers which residues causes for example electrical shorting, corrosion and degradation of the MTJ element. Their deposition on the sidewalls of the MTJ element may be detrimental to the memory device performance. US patent application US20050277206 describes a method for patterning a MTJ element wherein part of the soft layer is made inactive by implantation of oxygen elements. By implanting oxygen ions into part of the soft layer, this implanted part is transformed from a ferromagnetic material into an oxide material. The patterning method according to US20050277206 forms a so-called 'oxidation-only' dielectric material at the side parts of the soft layer.
There is thus a need for improved method for patterning a MTJ element, which method doesn't suffer from one or more of the deficiencies of the state-of-the-art.

### Summary of the disclosure

A first aspect relates to a method for patterning a magnetic tunneling junction (MTJ) element, the method comprising providing a stack of layers on a substrate, the stack of layers comprising a tunneling barrier layer sandwiched between a top ferromagnetic layer and a bottom ferromagnetic layer; defining outer parts surrounding a middle part for each of the layers; introducing metal or metalloid elements Z together with ion elements E into the outer parts of the top ferromagnetic layer thereby modifying the ferromagnetic properties of the outer parts of the top ferromagnetic layer into insulating properties.

According to embodiments, the bottom ferromagnetic layer comprises outer parts surrounding a middle part and the method further comprises also introducing the metal or metalloid elements Z together with the ion elements E into the outer parts of the bottom ferromagnetic layer thereby modifying the ferromagnetic properties of the outer parts of the bottom ferromagnetic layer into insulating properties.

The ferromagnetic properties of the middle part of the top ferromagnetic layer and optional bottom ferromagnetic layer remain unchanged as no metal or metalloid elements Z and ion elements E are introduced in this middle part.

According to embodiments insulating properties are amorphous glass-like properties.

According to embodiments, the top ferromagnetic layer is a soft layer and the bottom ferromagnetic layer is a hard layer or vice versa.

According to embodiments introducing metal or metalloid elements Z together with ion elements E comprises providing a metal layer on the top ferromagnetic layer, the metal layer comprising the metal or metalloid elements Z; implanting the ion elements E into the metal layer and diffusing or driving (part of) the metal or metalloid elements Z and the ion elements E into the underlying outer parts of the top ferromagnetic layer and optional also into the underlying outer parts of the bottom ferromagnetic layer.

According to embodiments, the method further comprises an annealing step after the step of introducing the ion elements E and the metal/metalloid elements Z. The annealing step may be done locally to the outer parts of the stack of layers.
According to embodiments the annealing step is a laser annealing step.

According to embodiments the method for patterning a MTJ element further comprises after providing the stack of layers and before the step of introducing the metal or metalloid elements together with the ion elements E, providing a hard mask on the middle part of the top ferromagnetic layer. This hard mask can be formed by depositing a hard mask layer on the top ferromagnetic layer and patterning the hard mask layer thereby exposing the outer parts of the top ferromagnetic layer.

According to embodiments implanting of the ion elements E is done using GCIB implantation.
According to embodiments, the ion elements E are chosen from nitrogen N, oxygen O, fluorine F or a mixture thereof.

According to embodiments the metal or metalloid elements Z are chosen from glass network formers or glass network intermediates or a mixture thereof.
According to embodiments glass network formers may be chosen from Si, Ge, P, V, As, B.
According to embodiments glass network intermediates may be chosen from Al, Sb, Zr, Ti, Pb, Be, Zn.

According to embodiments the stack of layers is patterned after the step of introducing metal or metalloid elements Z together with ion elements E or after the annealing step. Part of the outer parts of the stack of layers is thus removed. These parts can be removed by etching. Preferably a reactive ion etch is used.

According to embodiments part of outer parts of the top ferromagnetic layer may already be removed before the step of introducing metal or metalloid elements Z together with ion elements E. In this way the outer parts of the top ferromagnetic layer are thinned.

According to embodiments introducing metal or metalloid elements Z together with the ion elements E into the outer parts of the top (and optional also bottom) ferromagnetic layer comprises implanting metal or metalloid elements Z and implanting the ion elements E into the outer parts of the top (and optional also bottom) ferromagnetic layer. The outer parts of the top ferromagnetic material comprising ferromagnetic elements FM1 (and optional the outer parts of the bottom ferromagnetic material comprising ferromagnetic elements FM2) are converted into an amorphous glass-like insulating metal/metalloid layer FM1ZₓE_{z} with 0<x,z<1 (respectively an amorphous glass-like insulating metal/metalloid layer FM2ZₓE_{z} with 0<x,z<1 for the bottom ferromagnetic layer). The converted ferromagnetic material thus comprises a mixture of ferromagnetic elements FM1 (or FM2), metal or metalloid elements Z and ion elements E.
According to embodiments, the ferromagnetic material of the top ferromagnetic layer and the bottom ferromagnetic layer may be the same (i.e. FM1=FM2).

According to embodiments introducing metal or metalloid elements Z together with the ion elements E further comprises diffusing the metal or metalloid elements Z and the ion elements E also into the underlying outer parts of the bottom ferromagnetic layer.

According to embodiments the amorphous insulating metal/metalloid layer FM1ZₓE_{z} or FM2ZₓE_{z} is any of amorphous insulating metal/metalloid-oxide FM1ZₓO_{z} respectively FM2ZₓO_{z} or a metal/metalloid-fluoride material FM1ZₓF_{z} respectively FM2ZₓF_{z} or metal/metalloid-nitride material FM1ZₓN_{z} respectively FM2ZₓN_{z} with 0<x,z<1 or a mixture thereof. For example also a metal/metalloid-oxynitride material may be formed.

Another aspect relates to a magnetic tunneling junction (MTJ) element. The magnetic tunneling junction (MTJ) element comprises a stack of layers on a seed layer, the stack of layers comprising a tunneling barrier layer sandwiched in between a top ferromagnetic layer and a bottom ferromagnetic layer characterized in that the top ferromagnetic layer comprises a middle part and two outer parts aside of and surrounding the middle part, the middle part being ferromagnetic and comprising ferromagnetic elements FM1 and the outer parts being amorphous glass-like insulating and comprising a mixture of ferromagnetic elements FM1, ion elements E and metal/metalloid elements Z.
According to embodiments of the second inventive aspect the bottom ferromagnetic layer comprises a middle part and two outer parts aside of and surrounding the middle part, the middle part being ferromagnetic and comprising ferromagnetic elements FM2 and the outer parts being amorphous glass-like insulating and comprising a mixture of ferromagnetic elements FM2, ion elements E and metal/metalloid elements Z.
According to embodiments the ion elements E are chosen from oxygen O, nitrogen N and fluorine F or a mixture thereof.
According to embodiments the metal or metalloid elements Z are chosen from glass network formers or glass network intermediates or a mixture thereof.
According to embodiments glass network formers may be chosen from Si, Ge, P, V, As, B.
According to embodiments glass network intermediates may be chosen from Al, Sb, Zr, Ti, Pb, Be, Zn.

It is an advantage of the present disclosure that a high quality insulating material is formed such that the final MTJ stack has improved thermal stability, improved reliability, minor or no leakage through the insulating material.
It is an advantage of the present disclosure that there is no need to etch the complete MTJ stack by modifying part of the ferromagnetic layer (i.e. the soft layer for bottom pinned stacks or the hard layer for top pinned stacks) of the MTJ stack into an insulating material with low current density. The current density of the modified part of the ferromagnetic layer is preferably lower than 10⁻⁶A/cm² even more preferably lower than 10⁻⁹A/cm²
It is an advantage of different embodiments of the present disclosure that an amorphous glass-like insulating region is formed at outer parts of the soft layer of the MTJ element.
It is an advantage of different embodiments of the present disclosure that no detrimental etching steps of the ferromagnetic material are necessary for patterning the MTJ element.
It is an advantage of different embodiments of the present disclosure that by using a patterning method according to embodiments a precise control of size and shape of the MTJ element is achieved.
It is an advantage of different embodiments of the present disclosure that by using a patterning method according to embodiments contamination of the patterned MTJ element is reduced compared to prior art patterning techniques.
It is an advantage of different embodiments of the present disclosure that by using a patterning method according to embodiments the patterned MTJ element is less prone to electrical shorting.
It is an advantage of different embodiments of the present disclosure that by using a patterning method according to embodiments deterioration of the MTJ element is reduced.

### Brief description of the drawings

The disclosure will be further elucidated by means of the following description and the appended figures.
Figures 1 to 6 illustrate a schematic representation of different steps for a method for patterning a MTJ element according to embodiments of the present disclosure.
Figure 7 shows a flow chart for a method of patterning a MTJ element according to embodiments of the present disclosure.
Figures 8 to 11 illustrate a schematic representation of different steps for a method for patterning a MTJ element according to embodiments of the present disclosure.
Figure 12 shows a flow chart for a method of patterning a MTJ element according to embodiments of the present disclosure.
Figure 13 to 16 illustrates a schematic representation of method for patterning MTJ element according to embodiments of the present disclosure.

### Detailed description of the disclosure

The disclosure will be further elucidated by means of the following detailed description of several embodiments of the disclosure and the appended figures.

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

When reference is made to conductor, dielectric and insulator (or conductive, dielectric and insulating), the difference is defined relating to their electrical conductance. The current which can pass through reduces from conductor to dielectric and from dielectric to insulator. The conductance of a conductor is higher than the conductance of a dielectric and the conductance of a dielectric is higher than the conductance of an insulator. Otherwise said, the current density for an insulator is thus lower than the current density for a dielectric and the current density for a dielectric is lower than the current density for a conductor. Current properties of an insulator should be less than 10⁻⁶ A/cm², even less than 10⁻⁹ A/cm². Current properties of a dielectric are typically between 10⁻⁴ A/cm² and 10⁻⁶ A/cm².

Wherever reference is made to glass, glass network formers and glass network intermediates, there is referred to Shelby chapter 5 from R.K. Brow as retrieved from http://web.mst.edu/∼brow/PDF structure1.pdf for the theoretical background and definition of glass, glass network formers and glass network intermediates. Whereas crystals have a regular, repeating structure, glasses lack the periodic (long range) order of a crystal. Glasses have well-defined short range (nearest neighbour) bond arrangements. Glass constituents can be either network formers or network modifiers. Network formers are atoms that are directly incorporated into the network. Network modifiers are unable to be incorporated directly into the network of bonds, and thus force the network to be formed around them.

The starting point in the methods for patterning a MTJ stack according to the present disclosure is a ferromagnetic layer such as for example a CoFeB layer. Current density properties of such a ferromagnetic layer are about 10⁴A/cm². By introducing only oxygen elements, as in US20050277206, the ferromagnetic layer is oxidized and converted into a dielectric, for example CoFeB is converted into CoₓFe_{y}O_{z}. The ferromagnetic material is then transformed to a crystalline oxide matrix with current density properties about 10⁻⁶A/cm². It was surprisingly found that by additionally adding also metal/metalloid elements Z to the ferromagnetic layer FM according to embodiments of the present disclosure, together with ion elements E, the ferromagnetic material is transformed into a higher quality amorphous insulating matrix FMZₓE_{z}. The current density properties of such amorphous insulator are less than 10⁻⁶A/cm² or even less than 10⁻⁹A/cm².
It is an advantage of the present disclosure that there is no need to etch the complete stack of the MTJ element 1 to form an insulated MTJ stack thanks to the modification of part of the ferromagnetic layer (i.e. the soft layer for bottom pinned stacks or the hard layer for top pinned stacks) of the MTJ stack into a stable and high quality insulator metal/metalloid-oxide-like or metal/metalloid-fluoride-like or metal/metalloid-nitride-like matrix. The thereby formed high quality metal/metalloid-oxide-like or metal/metalloid-fluoride-like matrix or metal/metalloid-nitride-like is also very stable for subsequent (high temperature) annealing steps in the further processing of the MRAM device comprising the patterned MTJ stack.

For the purpose of teaching, reference is made in this disclosure to a bottom pinned MTJ element wherein the bottom ferromagnetic layer is the hard layer and the top ferromagnetic layer is the soft layer. The hard layer may comprise multiple layers such as for example a fixed magnetic layer 101 a on a pinning layer 101 b. It is clear for a person skilled in the art that top and bottom ferromagnetic layers may be interchanged as such forming a top pinned MTJ stack. Otherwise said; the order of the soft layer, tunneling barrier layer and hard layer might be reversed.

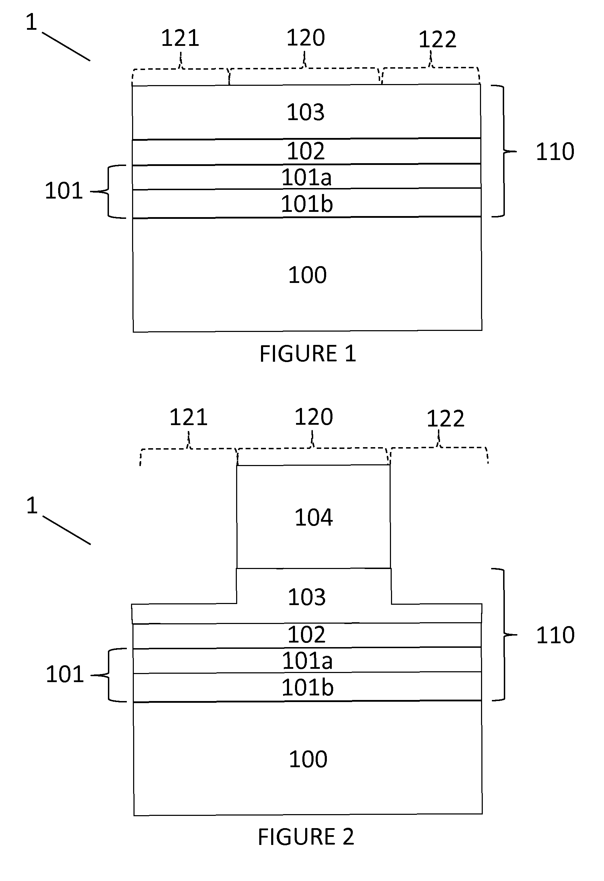

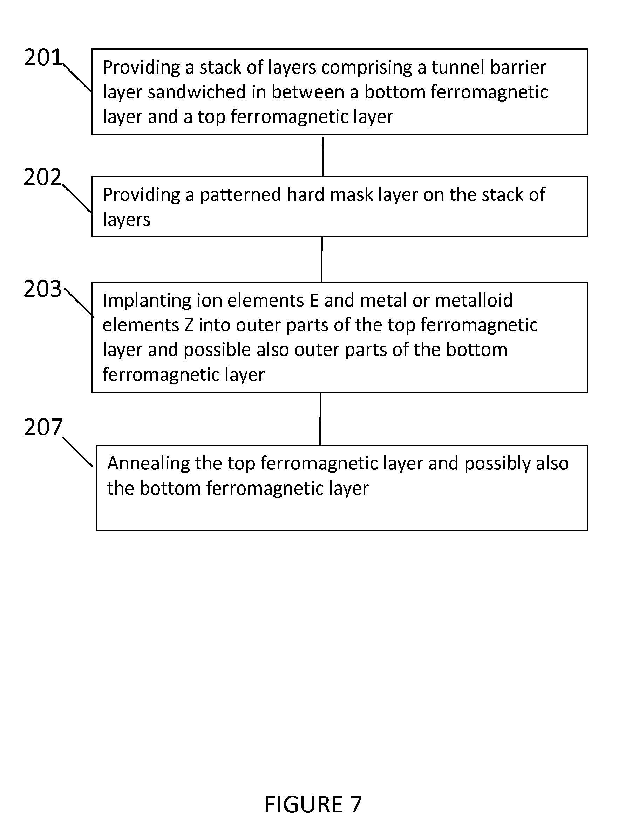

The flowchart of figure 7 describes different steps of a method for patterning a magnetic tunneling junction (MTJ) element according to embodiments of a first aspect. Step 201 describes providing a stack of layers comprising a tunneling barrier layer sandwiched in between a bottom ferromagnetic layer and a top ferromagnetic layer 103. Step 202 describes providing a patterned hard mask layer on the stack of layers. Step 203 describes implanting ion elements E and metal or metalloid elements Z into outer parts of the top ferromagnetic layer and optional also into outer parts of the bottom ferromagnetic layer. Step 207 describes annealing the top ferromagnetic layer and optionally also the bottom ferromagnetic layer. Each of the steps will now be further elucidated referring to figures 1 to 6.

A stack of layers 110 is provided on a substrate 100 (figure 1). A bottom ferromagnetic layer 101 is provided on the substrate 100. A tunneling barrier layer 102 is provided on the bottom ferromagnetic layer 101. A top ferromagnetic layer 103 is provided on the tunneling barrier layer 102. There may be additional layers present in between the tunneling barrier layer 102 and the top and/or bottom ferromagnetic layer 101, 103, such as for example spin-polarizing layers as known to a person skilled in the art. The thickness of the stack, in particular of the layer or layers to be removed during patterning, should preferably be kept as small as possible. The thicker the stack, the more difficult it is to remove all the layers together. All of the layers in the MTJ element described herein may be formed in a deposition system known to a person skilled in the art such as for example in (but not limited to) a physical vapor phase deposition (PVD) system.
The substrate may comprise a seed layer (not shown) which seed layer comprises for example Ta, Ru, or other conductive materials as known to a person skilled in the art. The stack of layers 110 provided comprises a tunneling barrier layer 102 sandwiched between a bottom ferromagnetic layer 101 and a top ferromagnetic layer 103. Each of the bottom ferromagnetic layer 101 and the top ferromagnetic layer 103 may be a single ferromagnetic layer such as for example CoFeB or it may comprise a stack with alternating (magnetic metal)/(non-magnetic metal) layers repeated n times, for example (Co/Pt)ₙ (n>=1) or with (magnetic metal)/(magnetic metal) layers repeated n times, for instance (Co/Ni)ₙ (n>=1). The bottom ferromagnetic layer 101 and the top ferromagnetic layer 103 may consist of the same ferromagnetic material or materials. The tunneling barrier layer 102 is preferably made of MgO. Also other insulating materials may be used for the tunneling barrier layer, such as AlₓO_{y}, TiₓO_{y}, ZnₓO_{y} (0<x,y).

For each of the layers a middle part 120 and two outer parts 121,122 at each side of (and next to) the middle part 120 are defined as shown in the cross section of figure 1. The middle part 120 is thus surrounded by the outer parts. Throughout the description, for the top ferromagnetic layer 103 there may be referred to the middle top part and two outer top parts. For the bottom ferromagnetic layer 101 there may be referred to the middle bottom part and two outer bottom parts. For the tunneling barrier layer 102 there may be referred to the middle tunneling part and two outer tunneling parts.

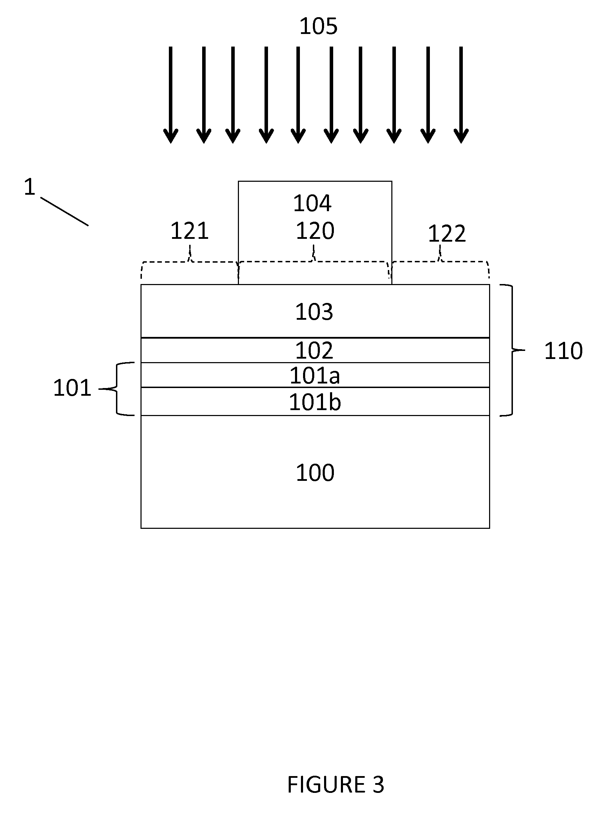

According to embodiments, a patterned hard mask 104 is provided on the stack of layers 110 (figures 2,3). This may be done using standard techniques known for a person skilled in the art such as using resist and lithography. The patterned hard mask 104 is present only on the middle part 120 of the stack of layers 110, more precisely on the middle part of the top ferromagnetic layer 103. The outer parts 121,122 of the stack of layers (more specifically the outer parts of the ferromagnetic layer) remain thus exposed.
The hard mask 104 may be for example an oxide or another suitable material which will protect the underlying middle part 120 of the stack of layers during the following steps. Afterwards this hard mask may be removed. Alternatively, the hard mask 104 may be formed of a conductive material such as a metal. As such, the hard mask 104 may remain in the final memory device and may be part of the top electrode of the MTJ element. The hard mask 104 should be thick enough such that the metal elements Z do not diffuse to the underlying layers via the hard mask. Depending thus on the material of the hard mask, the hard mask will remain on the MTJ element or will be removed in one of the later steps (after the introduction of the metal/metalloid elements Z and ion elements E).

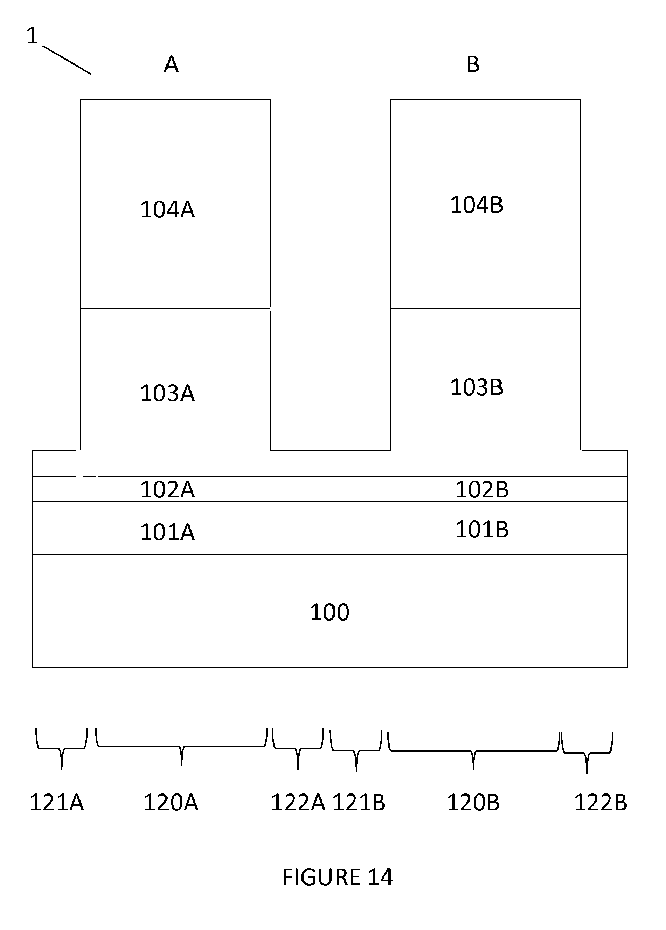

Part of the outer parts of the top ferromagnetic layer may be removed before the conversion step (203, 204) using the hard mask 104 (figure 2, figure 14) to reduce the layer thickness. Removing upper part of the outer parts of the top ferromagnetic layer may be done by etching, more preferably by reactive ion etching. It is advantageous for thick top ferromagnetic layers to etch already part of the top parts before the conversion step. For thick top ferromagnetic layers it could be difficult to completely convert these layers into amorphous glass-like insulator material as the metal/metalloid and ion elements need to diffuse then very deep through the stack. If the bottom ferromagnetic layer needs to be converted also, the depth through which the metal/metalloid Z and ion elements E need to diffuse is even deeper. In order to have the metal/metalloid Z and ion elements E diffused through all the needed layers, a high temperature budget or high implantation energies are necessary which on their turn could be detrimental for the device characteristics of the stack. Therefore part of the outer parts of the top ferromagnetic layer may be removed already before the conversion step, as such thinning down the top ferromagnetic layer.

After providing the hard mask 104, metal and/or metalloid elements Z together with ion elements E are introduced into the outer parts 121,122 of the top ferromagnetic layer 103, thereby modifying the ferromagnetic properties of the outer parts of the top ferromagnetic layer 103 into electrically inactive, i.e. insulating properties. These elements can be introduced by ion implantation 105. The exposed outer parts 121, 122 of the top ferromagnetic layer are exposed to an ion implantation 105 of ion element(s) E and metal/metalloid element(s) Z (figure 3). The metal/metalloid elements Z are chosen such that the resulting converted outer parts of the top ferromagnetic layer form a high quality insulator amorphous glass. The metal/metalloid element Z is preferably chosen from glass network formers such as Si, Ge, P, V, As, .. or glass network intermediates such as Al, Sb, Zr, ti, Pb, Be, Zn, ... or a mixture thereof. According to embodiments, different metal elements Z (Z1, Z2,..) may be introduced. However preferably only one metal/metalloid element Z is used. Ion elements E may be chosen from oxygen O, nitrogen N, fluorine F or a mixture thereof. The outer parts may be converted into a metal/metalloid-oxide (FMZₓO_{z}) or metal/metalloid-fluoride (FMZₓF_{z}) or metal/metalloid-nitride (FMZₓN_{z})) depending on the used ion elements E, with 0<x,y.

The combination of the ion elements E and the metal/metalloid elements Z enables glass formation and formation of an amorphous glass-like insulator in the ferromagnetic layer. The insulating properties of such high quality amorphous glass-like insulator are higher than the dielectric properties of the dielectric formed using the method of US20050277206.

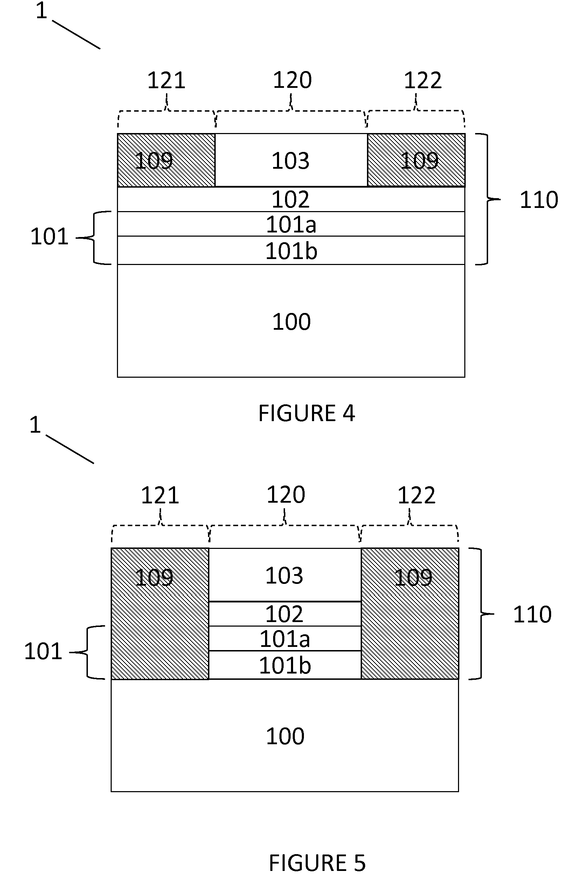

A feature of the present disclosure is to implant metal/metalloid elements together with oxygen, or fluoride or nitrogen into outer parts of the ferromagnetic layer. According to embodiments, implantation may be done in both the outer , parts of the top ferromagnetic layer 103 and the outer , parts of the bottom ferromagnetic layer 101.
The outer parts 109 of the top ferromagnetic layer 103 (and the outer parts of the bottom ferromagnetic layer 101 if also implanted) are thereby made electrically inactive and transformed into a stable metal/metalloid-oxide or metal/metalloid-fluoride material 109 with much better insulating properties compared to prior art. The middle part 120 of the top ferromagnetic layer 103 remains thus ferromagnetic and is not altered or converted or transformed (figure 4). Also the middle part of the bottom ferromagnetic layer remains ferromagnetic and is not altered or converted or transformed (figure 5).

According to embodiments, also the bottom ferromagnetic layer 101 may be partially transformed to an insulating material by introduction of metal/metalloid elements Z together with ion elements E into outer parts of the bottom ferromagnetic layer 101. The outer parts 110 of the bottom ferromagnetic layer are thereby made electrically inactive and transformed into a stable metal/metalloid insulator 109. The stable metal/metalloid insulator 109 may be a stable metal/metalloid-oxide or metal/metalloid-fluoride material or metal/metalloid-nitride material or a mixture thereof with much better insulating properties compared to prior art. The middle bottom part of the bottom ferromagnetic layer remains thus ferromagnetic and is not altered. An MTJ element 1 after conversion of the outer parts of both the top 103 and bottom 101 ferromagnetic layer is schematically shown in figure 5.

Different alternatives will now be described regarding the step of introducing the metal/metalloid elements Z together with ion elements E into outer parts of the ferromagnetic layers (top ferromagnetic layer and, if needed, also bottom ferromagnetic layer).

According to embodiments, the ion elements E and metal/metalloid elements Z are implanted into the outer parts of the ferromagnetic layers. This may be done together in one implantation process step or may be done separately in more than one implantation process step. The implantation process may be done using prior art ion beam techniques known for a person skilled in the art. The tilt angle of the implantation process is preferably between 0 and 90 degrees.

Due to the ion implantation of ion elements E and metal/metalloid elements Z into the exposed outer parts of the exposed top ferromagnetic layer 103, the ferromagnetic properties of the outer parts of the top ferromagnetic layer 103 are modified into insulating properties. The outer parts of the top ferromagnetic layer 103 are thus modified to an oxide-matrix or fluoride-matrix or nitride-matrix or mixture thereof 109 comprising the initial ferromagnetic material of the top ferromagnetic layer 103, the implanted ion elements, such as oxygen O or fluorine F or nitrogen N, and the implanted metal/metalloid elements Z.

After implantation, an anneal may be necessary for amorphization of the metal/metalloid-oxide or metal/metalloid-fluoride-matrix or metal/metalloid-nitride or mixture thereof in the outer parts 109 of the top ferromagnetic layer. A typical annealing condition would be laser anneal in the temperature range of 400 to 700 degrees Celsius. Diffusion of the metal/metalloid elements Z and the ion elements E take place both during the implantation step and the annealing step. The annealing step helps to further diffuse or drive the elements into the ferromagnetic layers after the implantation step. According to embodiments, the annealing step may be a rapid thermal annealing step. According to preferred embodiments, the annealing step is a localized thermal annealing step. A laser spike anneal may for example be used. It is an advantage of a localized annealing step, that only the important, i.e. the converted outer parts 109 of the MTJ stack are subject to the localized rapid thermal annealing step. The middle parts of the MTJ stack 110 are protected with a hard mask layer 104 such that they are not subject to the annealing step. By exposing the converted outer parts 109 to a localized rapid thermal annealing process, a high temperature may be reached for a short period of time duration which enables further diffusion of the elements into the ferromagnetic layers without degradation of the electrical device properties.

According the present disclosure, the material of at least the outer parts of the top ferromagnetic layer 103 is converted from ferromagnetic into insulating material. According to embodiments also the outer parts of the bottom ferromagnetic layer 103 may be converted from ferromagnetic into insulating material. Also the outer parts the tunneling barrier layer may be converted from an insulating material into another insulating material due to the introduction of additional elements (i.e. the metal/metalloid elements Z and the ion elements E). The tunnel barrier layer may thus alter into an intermixed insulating layer comprising the initial insulating material and additional elements.

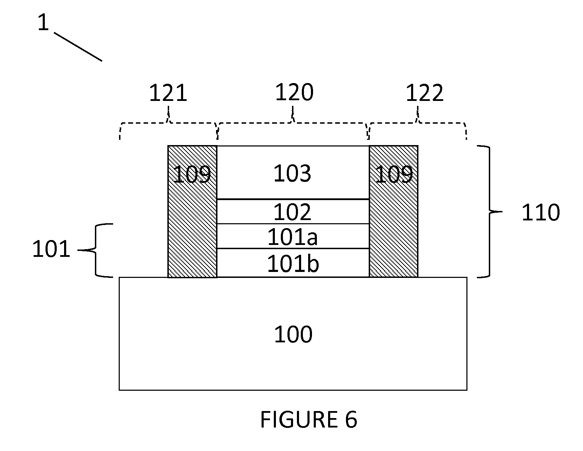

Figure 6 shows schematically a MTJ stack 1 according to embodiments wherein the outer parts 121,122 of all the layers of the stack 110 are converted resulting in a smaller MTJ stack i.e. the middle part 120 of the initial stack of layers remains. The middle part 120 of the different layers may thus not alter and ferromagnetic layers of the middle part remain unchanged and thus ferromagnetic.

After the conversion of the ferromagnetic layers, an etching step of the outer parts may be performed to reduce the width of the MTJ element 1. An exemplary final structure of the MTJ element after etching is shown in figure 6. Small part of the converted ferromagnetic material, i.e. of the amorphous glass material 109 of the outer parts 121, 122 remains present in the final MTJ element 1 in order to protect the middle part 102 of the ferromagnetic layers during further steps involving other etching or other detrimental process steps.

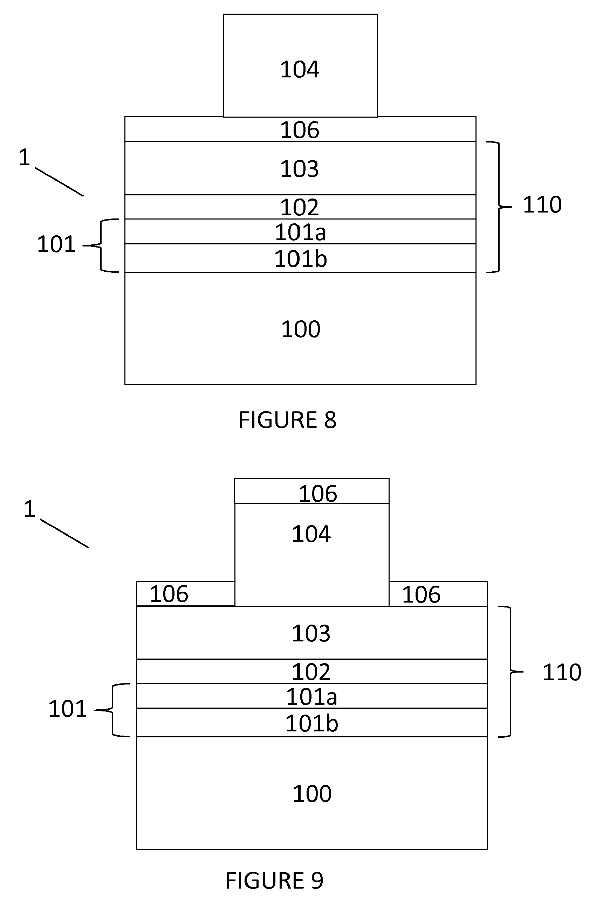

Whereas for the embodiments relating to figures 1 to 7, the ion elements E and metal/metalloid elements Z are introduced by one or more implantation steps, the embodiments relating to figures 8 to 12 describe the introduction of these elements by a combination of a metal/metalloid layer and an implantation step.

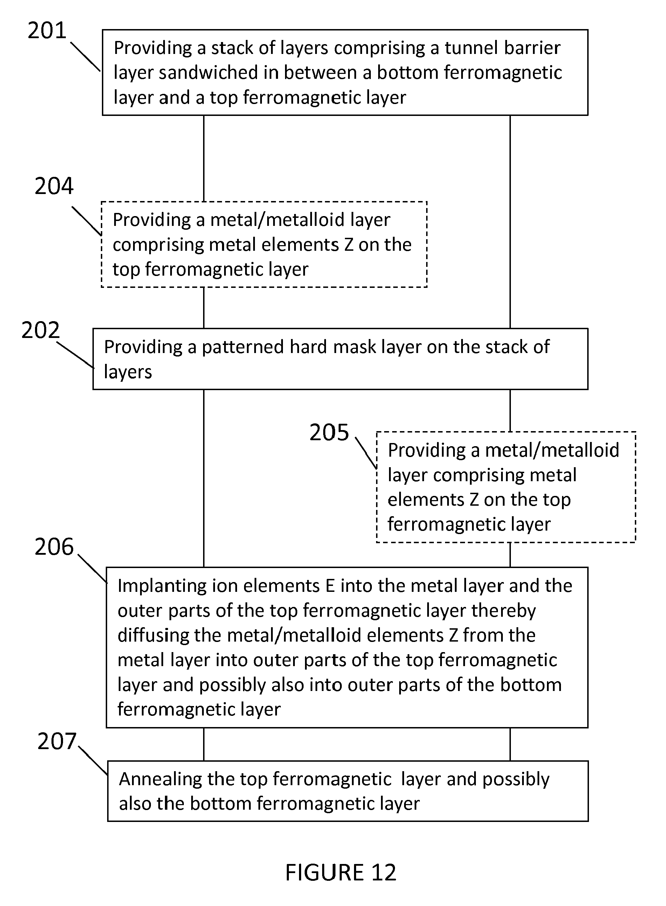

The flowchart of figure 12 describes different steps of a method for patterning a MTJ element according to embodiments of a first aspect. Step 201 describes providing a stack of layers comprising a tunneling barrier layer sandwiched in between a bottom ferromagnetic layer and a top ferromagnetic layer. Step 202 describes providing a patterned hard mask on the stack of layers. Step 204 and step 205 describe providing a metal/metalloid layer comprising metal elements Z on the top ferromagnetic layer, whereby this layer can be formed prior 204 to or after 205 the formation of the hard mask. Step 206 describes implanting ion elements E into the metal layer and outer parts of the top ferromagnetic layer, thereby diffusing the metal elements Z into outer parts of the top ferromagnetic layer, and optionally also into outer parts of the bottom ferromagnetic layer. Step 207 describes annealing the top ferromagnetic layer and, preferably also the bottom ferromagnetic layer. Each of the steps will now be further elucidated referring to figures 8 to 12.

According to embodiments, a metal/metalloid layer 106 is provided on the top ferromagnetic layer 101 of the stack of layers 110 (figures 8, 9). The metal/metalloid elements Z 108 in the metal/metalloid layer 106 are chosen such that the resulting. The metal/metalloid layer 106 comprises metal/metalloid elements Z 108 which are chosen such that a metal/metalloid-oxide (FMZₓO_{z}) or metal/metalloid-fluoride (FMZₓF_{z}) or metal/metalloid-nitride (FMZₓN_{z}) matrix is formed yielding an amorphous high quality glass-like insulator surrounding the reaming middle part 120 of the MTJ stack 110. converted outer parts of the top ferromagnetic layer form a high quality insulator amorphous glass. The metal/metalloid layer 106 may be provided using standard deposition techniques known for a person skilled in the art. The metal/metalloid element Z is preferably chosen from glass network formers such as Si, Ge, P, V, As or glass network intermediates such as Al, Sb, Zr, ti, Pb, Be, Znor a mixture thereof. The metal/metalloid layer 106 may thus for example be an Al-layer, a Ti-layer or a Ge-layer. The thickness of the metal/metalloid layer 106 should be selected in function of the thickness of the top ferromagnetic layer. The thicker the top ferromagnetic layer, the more metal/metalloid elements Z are needed to induce the conversion of the ferromagnetic material into insulating material, the thicker the metal/metalloid layer 106 preferably is. The thickness of the metal/metalloid layer 106 should preferably be in the range of 1.5 to 3nm.

According to embodiments, a hard mask 104 may be provided on the middle part 120 of the top ferromagnetic layer before (figure 9, step 204) or after (figure 8, step 205) providing the metal/metalloid layer 106. In the case the metal/metalloid layer 106 is provided on the hard mask 104, no metal/metalloid layer will be present between the hard mask 104 and the top ferromagnetic layer 103 in the middle part 120. Providing the hard mask 104 may be done using standard techniques known for a person skilled in the art such as using resist and lithography.
A main function of the hard mask layer 104 is to protect the middle part 120 of the top ferromagnetic layer 103 from the subsequent implantation and annealing step(s). The hard mask 104 is therefore present only on the middle part 120 of the stack of layers 110. The outer parts 121,122 of the stack of layers, and if already present the metal/metalloid layer 106, remains thus exposed. The hard mask 104 may be for example nitride or an oxide or even a metal For embodiments where the hard mask layer 104 comprises a metal, the exposed top part of the hard mask 104 may possibly also be converted to another material during the conversion step. As the hard mask layer 104 is thick enough, this does not form any problem for the further processing of the device. The MTJ stack 110 typically has a maximum thickness which needs to be converted which thickness is smaller than the thickness of the hard mask 104. For example, only 10nm of the top ferromagnetic layer 103 needs to be converted, which means that in case of a metal hard mask 104 also only 10nm from the top part of the hard mask layer will be converted. The hard mask 104 typically has a thickness of about 80nm.

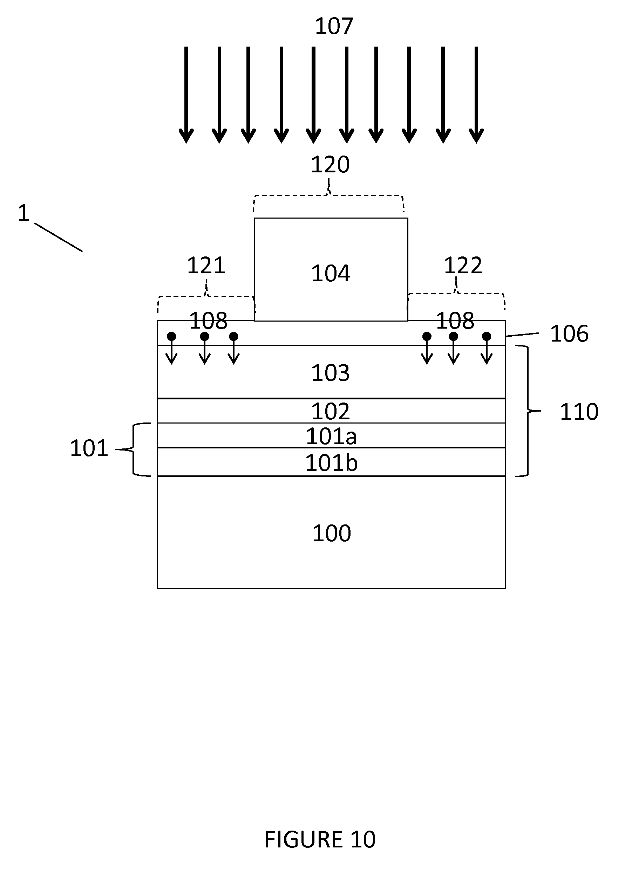

After providing the hard mask 104, the exposed outer parts 121,122 of the top ferromagnetic layer 103 are implanted 107 with ion elements E (figure 10). Due to the implantation 107 of the ion elements 107, at least part of the metal/metalloid elements Z 108 from the metal/metalloid layer 106 will enter together with the ion elements E the exposed outer parts of the underlying top ferromagnetic layer 103, thereby modifying the ferromagnetic properties of the outer parts of the underlying top ferromagnetic layer 103 into insulating properties. The outer parts of the top ferromagnetic layer 103 are thus modified to a matrix, e.g. an oxide-matrix or fluoride-matrix or nitride matrix 109, comprising the initial ferromagnetic material FM from the top ferromagnetic layer 103, the implanted ion elements E, e.g O, N, F, and the metal/metalloid elements Z diffused from the metal/metalloid layer 106.
The implantation process may be done using for example ion beam techniques. The tilt angle of the implantation process is preferably between 0 and 90 degrees.
The metal/metalloid Z elements of the metal layer 106 are chosen such that they form an amorphous, insulating, mixed glass-like insulator together with the ion elements E and the ferromagnetic material FM.
The metal/metalloid element Z may be chosen from so-called glass network formers, such as for example Si, Ge, P, V, or As, or so-called glass network intermediates, such as for example Al, Sb, Zr, ti, Pb, Be, or Zn or a mixture of glass network formers and glass network intermediates. The ion elements E are chosen from the group of nitrogen N, oxygen O, fluorine F or a mixture thereof.

According to preferred embodiments, gas cluster ion beam implantation (GCIB) may be used for implantation of the ion elements E. With this technique, the layer stack 110 to be patterned is exposed to a bombardment with gas clusters of a few hundred up to several thousands of gaseous atoms or molecules. At the moment of impact, the energy released per atom is very low, typically less than 10 eV, thereby creating low damage surface or shallow penetration of the active species into the substrate. Although the energy per atom is low, the energy density near the surface is very high and the heat released at the point of impact is very high, hence providing the energy for enhancing the chemical reactions and/or material evaporation. According to embodiments, the metal/metalloid layer 106 comprising metal elements Z is thus bombarded with ion elements E by GCIB implantation. At the same time, the surface of the metal/metalloid layer 106 receives - due to the use of GCIB - a high, but surface restricted thermal budget. In this way, the oxygen O or fluoride N implanted into and metal/metalloid elements Z 108 diffused into the outer parts 121, 122 of the top ferromagnetic layer 103 are intermixed at a temperature which allows direct metaloxide matrix formation in the outer parts of the top ferromagnetic layer. It is an advantage of using GCIB implantation that a subsequent annealing step to stabilize the metal/metalloid-oxide matrix is not necessary anymore.

After implantation, annealing may be necessary for amorphization of the metal/metalloid-oxide or metal/metalloid-fluoride-matrix or metal/metalloid-nitride or mixture 109 thereof in the outer top parts of the top ferromagnetic layer 103 . A typical annealing would be laser annealing in the temperature range of 400 to 700 degrees Celsius.
Diffusion of the metal/metalloid elements Z and the ion elements E take place both during the implantation of the ion elements and , if present, the annealing of the matrix 109 formed. Annealing helps to further diffuse the elements into the ferromagnetic layers after the implantation step. Metal/metalloid elements Z 108 from the metal/metalloid layer 106 are thus driven into the outer parts of the top ferromagnetic layer 103 during both the implantation step of oxygen and/or fluorine and/or nitrogen and a later annealing step.

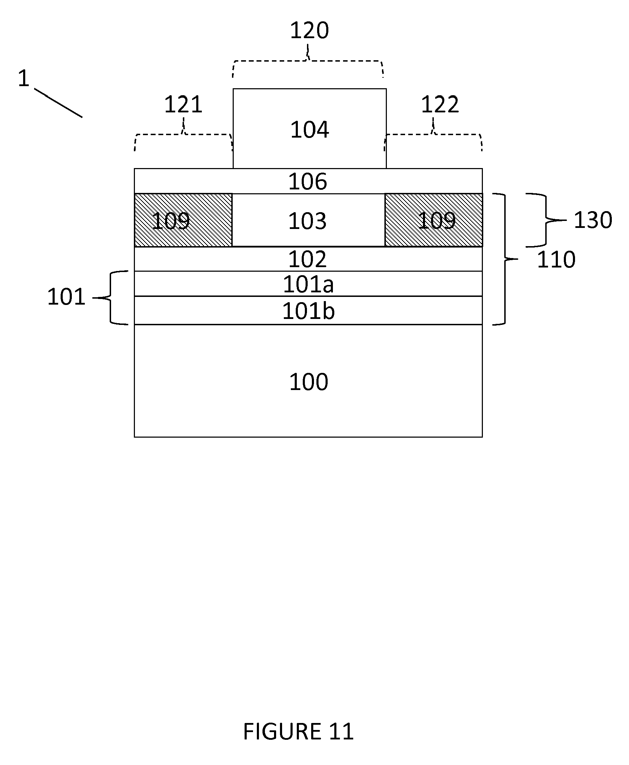

Figure 11 shows a schematic presentation of the MTJ stack 1 after conversion of outer parts 121, 122 of the top ferromagnetic layer. As already described before, also the underlying layers may be converted i.e. the outer parts 121, 122 of the barrier layer 102 and/or of the bottom ferromagnetic layer 101. In this case process parameters are adapted such that the ion elements E and metal/metalloid elements Z 180 may diffuse through the different layers. These parameters are for example: increasing the thickness of the metal layer 106, using a higher temperature in the annealing step or using higher implantation energies in the implantation step.

After the conversion of the ferromagnetic layers, an etching step of the outer parts may be performed to reduce the width of the MTJ element 1. An exemplary final structure of the MTJ element after an etching step shown in figure 11 will be similar to the one shown in figure 6, except for the presence of the metal layer 106 on the stack if the metal layer 106 is formed before the hard mask 104. Optionally, this metal layer 106 may be removed before narrowing the converted outer parts 109. Small part of the converted ferromagnetic material, i.e. of the amorphous glass material 109 (hatched parts) of the outer parts 122 remains present in the final MTJ element 1 in order to protect the middle part of the ferromagnetic layers during further steps involving other etching or other detrimental process steps.

Using additional process steps (such as for example typical back-end-of-line (BEOL) process steps), known for a person skilled in the art, the MTJ stack 1 may further be finalized towards an end-product, such as an STT-MRAM device.

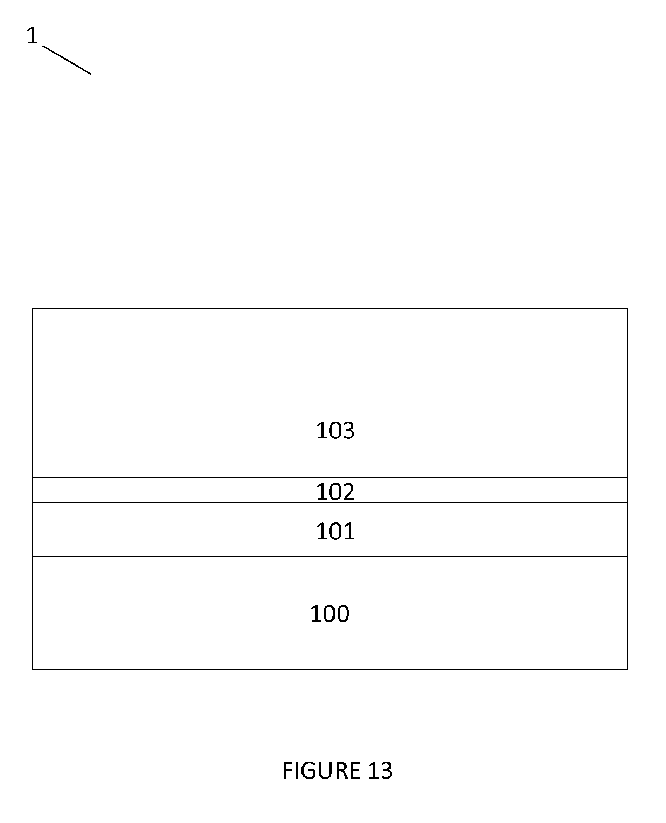

Figure 13 and figure 14 show a magnetic memory device comprising patterned MTJ stacks patterned according to embodiments of the present disclosure. As described already before, a stack of layers 110 is provided on a substrate 100, which substrate can comprise a seed layer and/or a bottom electrode of the magnetic memory device. The stack of layers 110 comprises a tunnel barrier layer 102 sandwiched between a top ferromagnetic layer 103 and a bottom ferromagnetic layer 101 (figure 13). According to embodiments, the stack of layers 110 is patterned using of hardmask 104A, 104B, thereby forming a left MTJ stack (A) and a right MTJ stack (B). For both stacks, outer 121 A, 122A, 121 B, 122B and middle parts 121 A, 121B may be defined as described above. Before converting the ferromagnetic properties of the outer parts of the top ferromagnetic layer 103 is removed thereby thinning the outer parts of the top ferromagnetic layer 103,compared to the as deposited thickness of the top ferromagnetic layer. The thickness of the middle part 120 of the top ferromagnetic layer, and of the stack 110, thus remains unchanged (figure 14).

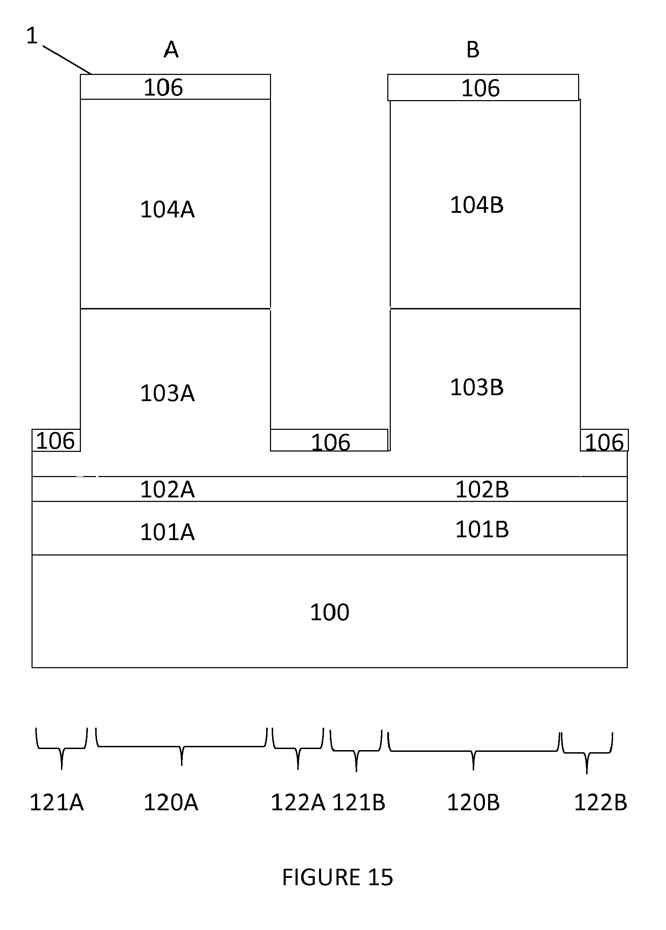

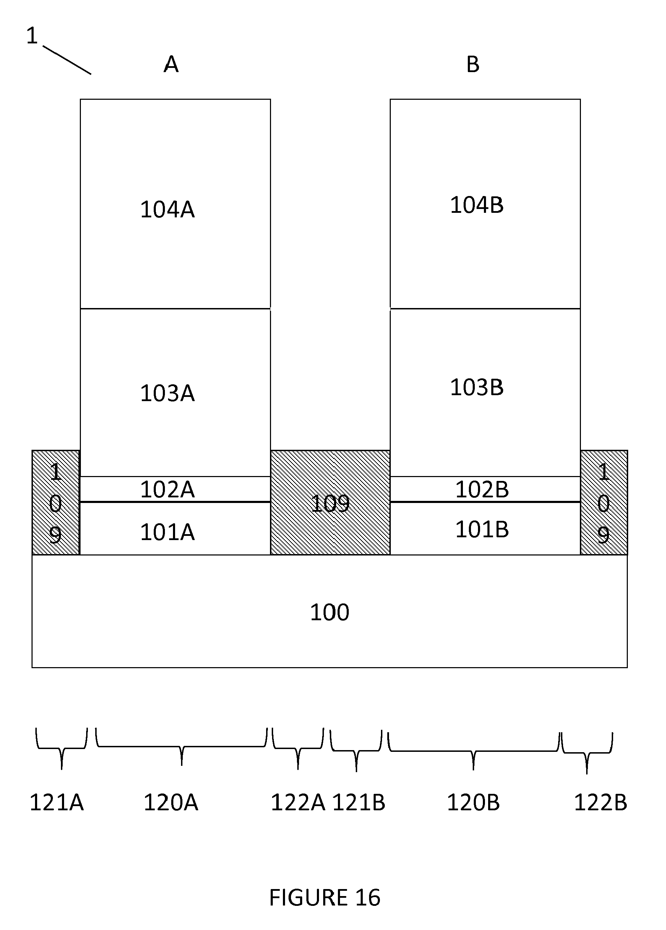

After partially patterning the top ferromagnetic layer, the exposed ferromagnetic layers in the outer parts 121A, 122A, 121B, 122B of the stack 110 are converted into insulating layers 109 (figure 16). This conversion may be done according to embodiments as described above, i.e. by providing a metal layer 106 (with metal elements Z) at least on the outer parts 121,122 of the top ferromagnetic layer 103 , and performing a GCIB implantation of ion elements E at least into the metal layer 106. Figure 15 illustrates the embodiment where the hard mask 14 is formed prior to the metal layer 16.
MTJ stack A and MTJ stack B are thus isolated from each other by thinning the outer parts and thereafter converting the remaining outer parts into an insulating material.

A second aspect of the disclosure relates to a magnetic tunneling junction (MTJ) element 1.
A MTJ element 1 typically comprises a tunneling barrier layer 102 sandwiched in between a bottom ferromagnetic layer 101 and a top ferromagnetic layer 103. If the MTJ stack of the element 1 is a so-called bottom pinned MTJ stack, the bottom ferromagnetic layer refers to the hard ferromagnetic layer and the top ferromagnetic layer refers to the soft ferromagnetic layer. If the MTJ stack is a so-called top pinned MTJ stack, the bottom ferromagnetic layer refers to the soft ferromagnetic layer and the top ferromagnetic layer refers to the hard ferromagnetic layer.

For the ease of understanding the disclosure, the illustrating figures refer to a bottom pinned MTJ stack. Figure 1 shows thus a MTJ element 1 comprising a tunneling barrier layer 102 sandwiched in between a hard ferromagnetic layer 101 - typically comprising a fixed magnetic layer 101 a and a pinning layer 101b - and a soft ferromagnetic layer 103. The soft ferromagnetic layer is often also referred to as the free magnetic layer. It is clear for a person skilled in the art that layers 101 and 103 may be interchanged as such forming a top pinned MTJ stack.

Figure 6 is a cross-sectional view illustrating the structure of a patterned MTJ element 1 according to embodiments. The MTJ element 1 comprises a stack of layers 110 on a substrate 100, the stack of layers 110 comprising a tunneling barrier layer 102 sandwiched in between a bottom ferromagnetic layer 101 and a top ferromagnetic layer 103. The bottom ferromagnetic layer 101 comprises a fixed magnetic layer 101 a and a pinning layer 101 b. The top ferromagnetic layer 103 comprises a middle part 103 and outer parts 109 aside of the middle part 103. The middle part 103 is ferromagnetic and comprises ferromagnetic material FM whereby the outer parts 109 are insulating and comprise an glass-like insulator matrix. The glass-like insulator matrix comprises the ferromagnetic material FM, ion elements E and metal/metalloid elements Z. The outer parts 109 of the top ferromagnetic layer 103 are thus electrically insulating, whereas the middle part 103 is electrically active, more specifically ferromagnetic. According to embodiments, also the bottom ferromagnetic layer 101 comprises a middle part and two outer parts aside of the middle part. Optionally, the middle part is ferromagnetic and comprises ferromagnetic material elements whereby the outer parts are insulating and comprise a mixture of the ferromagnetic material of the middle part, ion elements E and metal/metalloid elements Z. A final structure of the MTJ element after the final etching step is shown in figure 16.

An exemplary magnetic tunnel junction element 1 according to embodiments of the present disclosure may for example comprise:
- a CoFeB reference layer 101 formed on a seed layer (e.g. Ta or Ru) substrate 100,
- a MgO tunneling barrier layer 102 formed on the CoFeB reference layer 101, and
- a soft layer 103 comprising a middle part 120 of CoFeB and outer parts 109 of FM_{y}ZₓO_{z}, where FM comprises Co, Fe, where Z may be chosen from the group of glass network formers such as Si, Ge, P, V or As, .. ,and glass intermediates such as Al, Sb, Zr, ti, Pb, Be, or Zn or a mixture thereof, ... and O is oxygen, whereby 0<z,x,y and x+y+z =1

## Claims

1. A method for patterning a magnetic tunnel junction (MTJ) element comprising:
- providing a stack of layers (110) on a substrate (100), the stack of layers (110) comprising a tunneling barrier layer (102) sandwiched in between a top ferromagnetic layer (103) and a bottom ferromagnetic layer (101);
- defining outer parts (121, 122) surrounding a middle part (120) for each layer in the stack of layers (110);
- introducing metal or metalloid elements Z together with ion elements E into the outer parts (121,122) of the top ferromagnetic layer (103) thereby modifying the ferromagnetic properties of the outer parts of the top ferromagnetic layer (103) into insulating properties (109).

2. A method for patterning a MTJ element according to claim 1, further comprising introducing the metal or metalloid elements Z together with the ion elements E into the outer parts of the bottom ferromagnetic layer thereby modifying the ferromagnetic properties of the outer parts of the bottom ferromagnetic layer into insulating properties.

3. A method for patterning a MTJ element according to any of the previous claims, wherein the insulating properties are amorphous glass-like properties.

4. A method for patterning a MTJ element according to any of the previous claims, wherein introducing metal or metalloid elements Z together with the ion elements E comprises:
- providing on the top ferromagnetic layer (103) a metal layer (106) comprising the metal or metalloid elements Z;
- implanting the ion elements E into the metal layer (106), and
- diffusing the metal or metalloid elements Z and the ion elements E into the outer parts of the top ferromagnetic layer and, when dependent on claim 2, also into the outer parts of the bottom ferromagnetic layer.

5. A method for patterning a MTJ element according to any of the previous claims, further comprising annealing the MTJ element after introducing the metal or metalloid elements Z together with the ion elements E.

6. A method for patterning a MTJ element according to claim 5 wherein annealing is laser annealing.

7. A method for patterning a MTJ element according to any of the previous claims, further comprising after providing the stack of layers (110) and before introducing the metal or metalloid elements Z together with the ion elements E, providing a hard mask (104) on the middle part (120) of the top ferromagnetic layer (103).

8. A method for patterning a MTJ element according to any of the previous claims, wherein the ion elements E are introduced in the outer parts using Gas Clustered Ion Beams.

9. A method for patterning a MTJ element according to any of the previous claims, wherein the ion elements E are chosen from the group of nitrogen N, oxygen O or fluorine F.

10. A method for patterning a MTJ element according to any of the previous claims, wherein the metal or metalloid elements Z are chosen from the group of glass network formers, glass network intermediates or a mixture thereof.

11. A method for patterning a MTJ element according to any of the previous claims, further comprising patterning the stack of layers (110) after the step of introducing the metal or metalloid elements Z together with the ion elements E, or when dependent on claim 5, after annealing the MTJ element.

12. A method for patterning a MTJ element according to any of the previous claims, further comprising thinning an upper part of the top ferromagnetic layer (103) before introducing metal or metalloid elements Z together with ion elements E.

13. A magnetic tunnel junction (MTJ) element comprising:
a stack of layers (110) comprising a tunneling barrier layer (102) sandwiched in between a top ferromagnetic layer (103) and a bottom ferromagnetic layer (101),
**characterized in that**:
the top ferromagnetic layer (103) comprises a ferromagnetic middle part comprising a ferromagnetic material FM (103A, 103B, 120) and insulating outer parts (109, 121,122) surrounding the middle part, whereby the insulating outer parts (109) comprise a mixture of the ferromagnetic material FM, the ion elements E and the metal/metalloid elements Z, thereby having amorphous glass-like properties.

14. A magnetic tunnel junction (MTJ) element according to claim 13 wherein the mixture is selected from the group an amorphous insulating metal/metalloid-oxide, a metal/metalloidfluoride material or metal/metalloid-nitride material.

15. A magnetic tunnel junction (MTJ) element according to claim 13 or 14 wherein the metal/metalloid elements Z are chosen from the group of Si, Ge, P, V, As, Al, Sb, Zr, ti, Pb, Be, Zn, or a combination thereof.
